# EUROPEAN PATENT SPECIFICATION

(11) **EP 4 216 535 B1**
(45) Date of publication and mention of the grant of the patent: **27.08.2025**
(21) Application number: 21881964.7
(22) Date of filing: 18.10.2021
(51) Int. Cl.: H04N 23/54, H10F 39/00

(54) **CAMERA MODULE AND ELECTRONIC DEVICE**
KAMERAMODUL UND ELEKTRONISCHE VORRICHTUNG
MODULE DE CAMÉRA ET DISPOSITIF ÉLECTRONIQUE

(30) Priority: 21.10.2020 CN 202022366181 U
(43) Date of publication of application: 26.07.2023
(73) Proprietor: Huawei Technologies Co., Ltd., Shenzhen, Guangdong 518129 (CN)
(72) Inventor: ZHENG, Hong, Shenzhen, Guangdong 518129 (CN); ZENG, Lei, Shenzhen, Guangdong 518129 (CN)
(74) Representative: Epping - Hermann - Fischer
(86) International application number: PCT/CN2021/124444
(87) International publication number: WO 2022/083548

(56) References cited:
- WO-A1-2020/026639
- CN-A- 108 336 038
- CN-A- 111 666 783
- CN-U- 210 491 015
- CN-U- 211 505 870
- CN-U- 213 718 044
- CN-Y- 200 962 342
- US-A1- 2014 036 218
- US-A1- 2017 069 599
- US-A1- 2021 233 949

## Description

### TECHNICAL FIELD

This application relates to the field of imaging technologies, and in particular, to a compact camera module and an electronic device.

### BACKGROUND

In a conventional compact camera module, an image sensor is usually electrically connected to a circuit board by using a wire. However, as wires have poor stability, a problem, for example, wire sag or sway is very likely to occur, causing adjacent wires to come in contact with each other and then generate a short circuit, thereby affecting use reliability of the compact camera module.
US 2021/233949 A1 discloses a semiconductor device in which a heat releasing plate and a circuit board are disposed, wherein an imaging apparatus comprises an imaging device is enclosed in the semiconductor device
US 2017/069599 A1 discloses a microelectronic package comprising a substrate having an upper surface and a lower surface opposite the upper surface; a first wire bond wire of a first length coupled to the upper surface at a first end of the first wire bond wire; a first bond mass coupled to a second end of the first wire bond wire; a second wire bond wire of a second length coupled to the upper surface at a first end of the second wire bond wire; a second bond mass coupled to a second end of the second wire bond wire, wherein the first wire bond wire and the second wire bond wire laterally jut out horizontally away from the upper surface of the substrate for at least a distance of approximately 2 to 3 times a diameter of both the first wire bond wire and the second wire bond wire.

### SUMMARY

The invention is defined by the appended claims. This application provides a compact camera module and an electronic device, to prevent wires from generating sag or sway that causes adjacent wires to come in contact with each other and then generate a short circuit, thereby improving reliability of the compact camera module.

According to a first aspect, this application provides a compact camera module that may be used in an electronic device. The compact camera module includes an image sensor, a circuit board, first wires, second wires, and an insulation adhesive part. The image sensor is disposed on the circuit board, the first wires connect the circuit board to the image sensor, the second wires connect the circuit board to the image sensor and are spaced from the first wires, lengths of the second wires are greater than lengths of the first wires, and the insulation adhesive part is in contact with a top surface of the circuit board and covers at least a part of each first wire and a part of each second wire that are close to the circuit board.

The insulation adhesive part may be formed after being cured in a manner of natural curing, ultraviolet curing, thermal curing or the like following a dispensing process.

In the compact camera module shown in this application, the insulation adhesive part covers at least the part of the first wire and the part of the second wire that are close to the circuit board, to protect and fix the first wires and the second wires, so that loop stability of the first wires and the second wires is improved, and the first wires and the second wires are prevented from having wire sway or sag caused by a touch of a person during assembly of the compact camera module, or are prevented from having wire sway or sag due to overstress from external pressure during use of the compact camera module. In this way, the first wires and the second wires are prevented from coming in contact with each other and generating a short circuit because of wire sway or sag.

In an implementation, there are a plurality of first wires and a plurality of second wires, and the plurality of first wires and the plurality of second wires are in alternately arranged in a direction parallel to the top surface of the circuit board.

In an implementation, in a Y-axis direction, the plurality of first wires and the plurality of second wires are in alternately arranged. The Y-axis direction is a width direction of the compact camera module.

It should be understood that that the plurality of first wires and the plurality of second wires are in alternately arranged means that the plurality of first wires and the plurality of second wires are not arranged simply one classification after another, but there are one or more second wires between two first wires, or there are one or more first wires between two second wires.

In an implementation, the insulation adhesive part is further in contact with a top surface of the image sensor and covers a part of each first wire and a part of each second wire that are close to the image sensor, to assist in fixing the first wires and the second wires and improve the loop stability of the first wires and the second wires.

In an implementation, the top surface of the image sensor includes a photosensitive area and a non-photosensitive area surrounding the photosensitive area, and the insulation adhesive part is outside the photosensitive area, to prevent the insulation adhesive part from affecting the photosensitive area on receiving light for imaging, thereby improving imaging quality of the compact camera module.

In the compact camera module shown in this implementation, a simple dispensing and curing device may be used, and the insulation adhesive part may be formed after a dispensing and curing process to protect the first wires and the second wires, without a need to use a high-precision plastic packaging mold for plastic packaging of the first wires and the second wires. This avoids a microcrack or even damage due to excessive stress on the image sensor if the image sensor is squeezed by the plastic packaging mold, and helps reduce production costs of the compact camera module and improve a yield rate.

In an implementation, the insulation adhesive part covers highest positions of the first wires and the second wires, to improve the loop stability of the first wires and the second wires.

The highest positions of the first wires and the second wires refer to positions of the first wires and the second wires that are farthest from the top surface of the circuit board.

In an implementation, the insulation adhesive part fully covers the first wires and the second wires, to fully protect and fix the first wires and the second wires and ensure the loop stability of the first wires and the second wires.

In an implementation, the image sensor is disposed on the top surface of the circuit board, or the circuit board is provided with a mounting groove, an opening of the mounting groove is on the top surface of the circuit board, and the image sensor is disposed on the mounting groove, and the insulation adhesive part is further in contact with a lateral surface of the image sensor.

In an implementation, first pads and second pads that are spaced from each other are disposed on the top surface of the image sensor, first gold fingers and second gold fingers that are spaced from each other are disposed on the top surface of the circuit board, the first gold fingers and the second gold fingers are exposed relative to the image sensor, the second gold fingers are on a side on which the first gold fingers face away from the image sensor, the first wires connect the first gold fingers to the first pads, the second wires connect the second gold fingers to the second pads, and the insulation adhesive part covers the first gold fingers and the second gold fingers.

In an implementation, the lengths of the first wires range from 200 µm to 1,000 µm, and the lengths of the second wires range from 600 µm to 1,400 µm.

That the lengths of the first wires range from 200 µm to 1,000 µm means that a length of each first wire may not only be any value between 200 µm and 1,000 µm, but may alternatively be the endpoint value 200 µm or 1,000 µm. Similarly, that the lengths of the second wires range from 600 µm to 1,400 µm means that a length of each second wire may not only be any value between 600 µm and 1,400 µm, but may alternatively be the endpoint value 600 µm or 1,400 µm.

In an implementation, a distance between each first wire and each second wire is greater than or equal to 40 µm.

In an implementation, the compact camera module further includes a filter holder, an optical filter, a lens holder, and a lens. The filter holder is disposed on a top side of the circuit board, the filter holder has an aperture corresponding to the image sensor, the optical filter is disposed on the filter holder and covers the aperture, the lens holder is disposed on a top side of the filter holder, and the lens is disposed on an inside of the lens holder, to gather light from outside the compact camera module. In this case, the lens can gather light from outside, and transmit the light gathered from outside to the image sensor through the optical filter, to form a corresponding image on the image sensor.

According to a second aspect, this application provides an electronic device, including a housing and any one of the foregoing compact camera modules, where the compact camera module is disposed inside the housing.

In this application, as the insulation adhesive part covers at least the part of the first wire and the part of the second wire that are close to the circuit board, to protect and fix the first wires and the second wires, the loop stability of the first wires and the second wires is improved, and the first wires and the second wires are prevented from having wire sway or sag caused by a touch of a person during assembly of the compact camera module, or are prevented from having wire sway or sag due to overstress from external pressure during use of the compact camera module, so that the first wires and the second wires are prevented from coming in contact with each other and generating a short circuit because of wire sway or sag. This can reduce a fault feedback ratio of the compact camera module and help extend service life of the electronic device.

### BRIEF DESCRIPTION OF DRAWINGS

To describe technical solutions in embodiments of this application or in the background more clearly, the following briefly describes the accompanying drawings for describing the embodiments of this application or the background.
FIG. 1 is a schematic diagram of a structure of an electronic device according to an embodiment of this application;
FIG. 2 is a schematic diagram of a structure of a compact camera module in the electronic device shown in FIG. 1;
FIG. 3 is a schematic diagram of a partial decomposition structure of the compact camera module shown in FIG. 2 according to an embodiment;
FIG. 4 is a schematic cross-section diagram of a structure of the compact camera module shown in FIG. 2 that is cut in a direction I-I;
FIG. 5 is a schematic diagram of a partially assembled structure of a circuit board and an image sensor in the compact camera module shown in FIG. 3;
FIG. 6 is a schematic cross-section diagram of the structure shown in FIG. 5 that is cut in a direction II-II;
FIG. 7 is a schematic diagram of a partially assembled structure of a circuit board and an image sensor of a compact camera module in a second electronic device according to an embodiment of this application;
FIG. 8 is a schematic cross-section diagram of the structure shown in FIG. 7 that is cut in a direction III-III;
FIG. 9 is a schematic diagram of a partially assembled structure of a circuit board and an image sensor of a compact camera module in a third electronic device according to an embodiment of this application;
FIG. 10 is a schematic cross-section diagram of the structure shown in FIG. 9 that is cut along a direction IV-IV;
FIG. 11 is a schematic diagram of a partially assembled structure of a circuit board and an image sensor of a compact camera module in a fourth electronic device according to an embodiment of this application; and
FIG. 12 is a schematic cross-section diagram of the structure shown in FIG. 11 that is cut in a direction V-V

### DESCRIPTION OF EMBODIMENTS

The following describes embodiments of this application with reference to the accompanying drawings in the embodiments of this application.

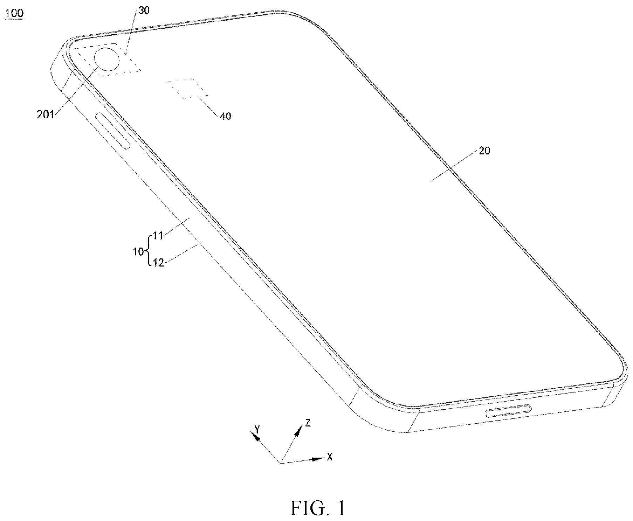

Refer to FIG. 1. FIG. 1 is a schematic diagram of a structure of an electronic device 100 according to an embodiment of this application.

The electronic device 100 may be an electronic product having a photographing function, for example, a mobile phone, a tablet computer, a laptop computer, a head unit, a point-of-sale terminal (point-of-sale terminal, POS machine for short), or a wearable device. The wearable device may be a smart band, a smart watch, augmented reality (augmented reality, AR) glasses, virtual reality (virtual reality, VR) glasses, or the like. In this embodiment of this application, an example in which the electronic device 100 is a mobile phone is used for description.

For ease of description, it is specified that a width direction of the electronic device 100 is an X-axis direction, a length direction of the electronic device 100 is a Y-axis direction, and a thickness direction of the electronic device 100 is a Z-axis direction, where the X-axis direction, the Y-axis direction, and the Z-axis direction are perpendicular to each other.

In this embodiment, the electronic device 100 includes a housing 10, a display module 20, a compact camera module 30, and an image processor 40. The housing 10 includes a frame 11 and a rear cover 12, and the rear cover 12 is fixed on one side of the frame 11. The frame 11 and the rear cover 12 may be fixed to each other by assembly, or may be an integrally formed structure.

The display module 20 is disposed in the housing 10, and is enclosed by the housing 10, to form an interior of the electronic device 100. Specifically, the display module 20 is fixed on a side, of the frame 11, that faces away from the rear cover 12. In other words, the display module 20 and the rear cover 12 are fixed on two opposite sides of the frame 11. The display module 20 is provided with a light-transmitting area 201, and light outside the electronic device 100 may enter the electronic device 100 through the light-transmitting area 201.

The compact camera module 30 and the image processor 40 are disposed inside the housing 10. An interior of the housing 10 is the interior of the electronic device 100. The compact camera module 30 can gather light from outside the electronic device 100 through the light-transmitting area 201, and form corresponding image data. The image processor 40 is electrically connected to the compact camera module 30, and the image processor 40 is configured to obtain the image data from the compact camera module 30 and process the image data. The image data processed by the image processor 40 may be displayed by the display module 20, and may further be stored in a memory of the electronic device 100, or may be stored in the cloud by the electronic device 100.

In the electronic device 100 shown in this embodiment, the compact camera module 30 is on a side of the electronic device 100 that is close to the display module 20, and is used as a front-facing compact camera module of the electronic device 100. It should be noted that, in another embodiment, the compact camera module 30 may alternatively be on a side of the electronic device 100 that faces away from the display module 20, and is used as a rear-facing compact camera module of the electronic device 100. In this case, a photographing opening is provided on the rear cover 12, and the compact camera module 30 gathers light from outside the electronic device 100 through the photographing opening on the rear cover 12. In other words, the compact camera module 30 may be used as the front-facing compact camera module of the electronic device 100, or may be used as the rear-facing compact camera module of the electronic device 100. Alternatively, the electronic device 100 may include a plurality of (two or more) compact camera modules 30. At least one of the compact camera modules 30 is used as the front-facing compact camera module of the electronic device 100, and at least one of the compact camera modules 30 is used as the rear-facing compact camera module of the electronic device 100.

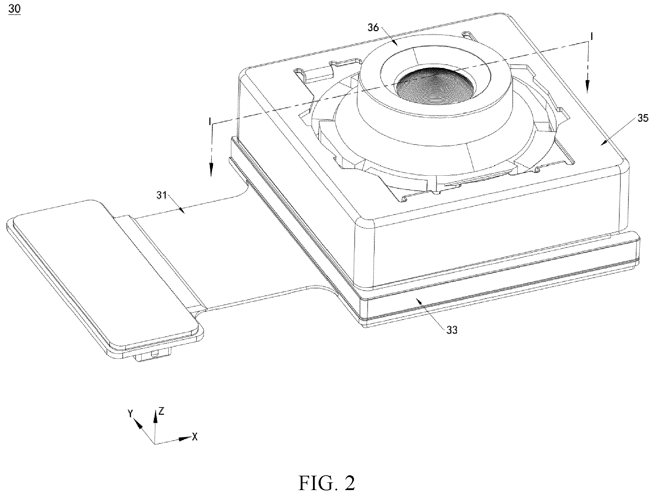

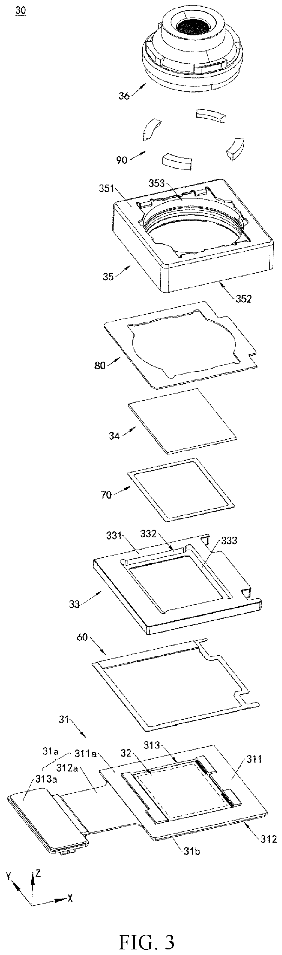

Refer to FIG. 2 and FIG. 3. FIG. 2 is a schematic diagram of a structure of the compact camera module 30 in the electronic device 100 shown in FIG. 1. FIG. 3 is a schematic diagram of a partial decomposition structure of the compact camera module 30 shown in FIG. 2 according to an embodiment. A width direction of the compact camera module 30 is an X-axis direction, a length direction of the compact camera module 30 is a Y-axis direction, and a height direction of the compact camera module 30 is a Z-axis direction.

In an embodiment, the compact camera module 30 includes a circuit board 31, an image sensor 32, a filter holder 33, an optical filter 34, a lens holder 35, and a lens 36. The circuit board 31 is electrically connected to the image processor 40, so that the compact camera module 30 is electrically connected to the image processor 40. The circuit board 31 includes a top surface 311 and a bottom surface 312 that are opposite to each other. Both the top surface 311 and the bottom surface 312 of the circuit board 31 are parallel to an X-Y plane (or may be almost parallel to the X-Y plane, that is, a slight deviation is allowed). In other words, both the top surface 311 and the bottom surface 312 of the circuit board 31 are perpendicular to the Z-axis direction (or may be almost perpendicular to the Z-axis direction, that is, a slight deviation is allowed). The circuit board 31 is provided with a mounting groove 313, and an opening of the mounting groove 313 is on the top surface 311 of the circuit board 1. Specifically, the opening of the mounting groove 313 is in a middle area of the top surface 311, and the mounting groove 313 is cut into the bottom surface 312 from the top surface 311 of the circuit board 1.

It should be noted that the terms of locality such as "top" and "bottom" in this application are descriptions with reference to orientations in FIG. 2, and do not indicate or imply that a described apparatus or element must have a particular orientation or be configured and operated in a particular orientation, and therefore cannot be understood as a limitation on this application.

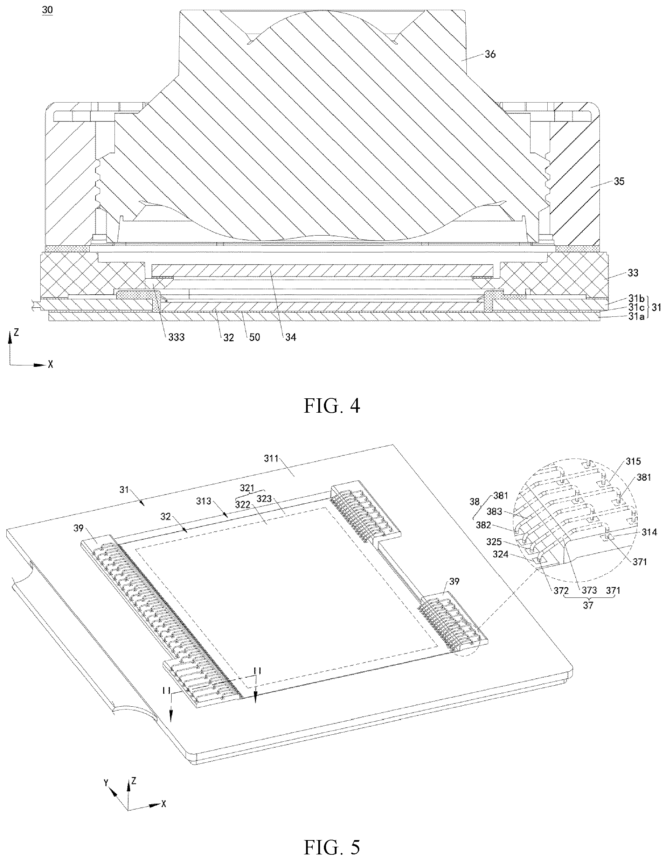

Also refer to FIG. 4. FIG. 4 is a schematic cross-section diagram of a structure of the compact camera module 30 shown in FIG. 2 that is cut in a direction I-I. "Cutting in the direction I-I" means cutting along a line I-I and a plane on which there are arrows at the two ends of the line I-I. Descriptions of the accompanying drawings below shall be understood in the same way.

In this embodiment, the circuit board 31 includes a substrate 31a and a bottom layer 31b. A top surface of the bottom layer 31b is fixedly connected to a bottom surface of the substrate 31a. The top surface of the circuit board 31 is formed on a top surface of the substrate 31a, and a bottom surface of the circuit board 31 is formed on a bottom surface of the bottom layer 31b. The bottom layer 31b is configured to reinforce the substrate 31a, so that the circuit board 31 is strong enough in structure to better support other components and structures. For example, the bottom layer 31b may be made of a stainless steel, copper, steel, or ceramic material. In addition, the bottom layer 31b may be further configured to conduct heat, so that heat of the circuit board 31 and a component fixed to the circuit board 31 can be dissipated quickly, thereby improving reliability of the compact camera module.

For example, the circuit board 31 may further include an adhesive bonding layer 31c. The adhesive bonding layer 31c is between the bottom layer 31b and the substrate 31a. The top surface of the bottom layer 31b is bonded with the adhesive bonding layer 31c, the adhesive bonding layer 31c is bonded with the bottom surface of the substrate 31a, and the bottom layer 31b and the substrate 31a are fixed to each other by adhesive bonding. The adhesive bonding layer 31c may be a conductive adhesive or a non-conductive adhesive. In some other implementations, the bottom layer 31b may alternatively be fixed to the substrate 31a by welding. For example, the circuit board 31 may further include a solder layer. The solder layer is between the bottom layer 31b and the substrate 31a, and is configured to fixedly connect the bottom layer 31b and the substrate 31a.

The circuit board 31 may be a rigid-flex circuit board. As shown in FIG. 3, the substrate 31a includes a first rigid board part 311a, a flexible board part 312a, and a second rigid board part 313a that are sequentially arranged. A board surface size of the first rigid board part 311a is greater than a board surface size of the second rigid board part 313a. The first rigid board part 311a and the second rigid board part 313a are rigid boards, the flexible board part 312a is a flexible board, and the flexible board gets bent more easily than the rigid board. The bottom layer 31b is fixed to the first rigid board part 311a, and a top surface of the first rigid board part 311a that is away from the bottom layer 31b is the top surface 311 of the circuit board 31 in the foregoing descriptions. The circuit board 31 may further include a stiffener fixed to the second rigid board part 313a. Alternatively, the substrate 31a is a flexible board, and the substrate 31a includes a first area, a second area, and a third area that are sequentially arranged. A size of the first area is greater than a size of the third area. The bottom layer 31b is fixed to the first area, and a top surface of the first area that is away from the bottom layer 31b is the top surface 311 of the circuit board 31 in the foregoing descriptions. The circuit board 31 may further include a stiffener fixed to the second area.

As shown in FIG. 4, the substrate 31a has a through-hole (not marked in the figure), and the mounting groove 313 (as shown in FIG. 3) includes the through-hole on the substrate 31a. The adhesive bonding layer 31c (or the solder layer) has a through-hole (not marked in the figure), and the through-hole in the adhesive bonding layer 31c is interconnected to the through-hole on the substrate 31a. In this embodiment of this application, that two spaces are "interconnected" means that the two spaces are connected and drilled through. The mounting groove 313 further includes the through-hole in the adhesive bonding layer 31c (or the solder layer). A groove bottom wall of the mounting groove 313 is formed with an area of the top surface of the bottom layer 31b that faces the through-hole on the substrate 31a. In this embodiment, manufacturing difficulty of the mounting groove 313 is low, helping improve manufacturing precision. In some other embodiments, the mounting groove 313 may further include a depression formed on the substrate 31a. In this case, the mounting groove includes the through-hole formed on the substrate 31a, the through-hole formed in the adhesive bonding layer 31c, and the depression formed in the bottom layer 31b.

The image sensor 32 is disposed on the circuit board 31, and is electrically connected to the circuit board 31. In this embodiment, the image sensor 32 is disposed in the mounting groove 313. In other words, the image sensor 32 can be fixed to the circuit board 31 from a top side of the circuit board 31. Specifically, the image sensor 32 is disposed on the groove bottom wall of the mounting groove 313. The image sensor 32 is disposed in a middle area of the groove bottom wall of the mounting groove 313, and is spaced from a groove side wall of the mounting groove 313. For example, the image sensor 32 may be disposed on the groove bottom wall of the mounting groove 313 by adhesive bonding. For example, the compact camera module 30 may include a first adhesive bonding layer 50, and the first adhesive bonding layer 50 bonds the image sensor 32 and the groove bottom wall of the mounting groove 313 together. The image sensor 32 may be a chip.

In this embodiment, a height of the image sensor 32 is less than a depth of the mounting groove 313 on the circuit board 31. The height of the image sensor 32 is a dimension of the image sensor 32 of the compact camera module 30 in a height direction (that is, the Z-axis direction shown in the figure). In this case, the image sensor 32 is fully embedded into the circuit board 31, and both the image sensor 32 and the circuit board 31 can use a thickness space of the compact camera module 30, thereby helping reduce a height of the compact camera module 30.

The filter holder 33 is disposed on a top side of the circuit board 31. In this embodiment, the filter holder 33 is disposed on the top surface 311 of the circuit board 31. Specifically, the filter holder 33 is disposed in an edge area of the top surface 311, and covers the top of the image sensor 32. For example, the filter holder 33 may be disposed on the top surface 311 of the circuit board 31 by adhesive bonding. For example, the compact camera module 30 may include a second adhesive bonding layer 60, and the second adhesive bonding layer 60 bonds the filter holder 33 and the top surface 311 of the circuit board 31 together.

It should be noted that that the filter holder 33 is disposed on the top side of the circuit board 31 means that at least a large part of the filter holder 33 is on the top side of the circuit board 31. In this embodiment, the filter holder 33 is cooperatively fixed to the top surface 311 of the circuit board 31. In another embodiment, the filter holder 33 may alternatively be cooperatively fixed to a lateral surface (not marked in the figure) of the circuit board 31, or the filter holder 33 may be cooperatively fixed to the top surface 311 and a lateral surface of the circuit board 31.

The filter holder 33 includes a top surface 331 that faces away from the circuit board 31. The filter holder 33 has an aperture 332, and an opening of the aperture 332 is on the top surface 331 of the filter holder 33. Specifically, the opening of the aperture 332 is in a middle area of the top surface 331, and the aperture 332 is cut into the circuit board 31 from the top surface 331 of the filter holder 33 through the filter holder 33 in the Z-axis direction. The aperture 332 corresponds to the image sensor 32. It should be noted that that the aperture 332 corresponds to the image sensor 32 means that a part or all of a projection of the aperture 332 on the circuit board 31 overlaps with the image sensor 32, to ensure that the image sensor 32 can receive light that enters the filter holder 33 through the aperture 332. "Correspond to" in the following descriptions is understood in the same way.

In addition, the aperture 332 is a sealed hole (that is, the aperture 332 has walls all around). A wall of the aperture 332 may be perpendicular to or tilted relative to the top surface 331 of the filter holder 33. Specifically, the wall of the aperture 332 partially protrudes to form a support part 333. The support part 333 is a continuous closed ring. In another embodiment, the support part 333 may alternatively be a non-continuous ring. It should be understood that a shape of the support part 333 is not limited to a square ring shown in FIG. 3, and may alternatively be a circular ring. This is not specifically limited in this application.

In some embodiments, the filter holder 33 may further have a positioning marker (not shown in the figure). Specifically, the positioning marker is on the top surface 331 of the filter holder 33, so that fast positioning of the lens holder 35 with the filter holder 33 can be implemented conveniently during assembly of the compact camera module 30. This improves precision and efficiency of assembling the lens holder 35 and the filter holder 33. For example, there may be four positioning markers, and the four positioning markers are disposed surrounding the aperture 332 and spaced from each other. It should be noted that in some other embodiments, the filter holder 33 may have no positioning marker, and positioning of the lens holder 35 with the filter holder 33 may be implemented in another manner. This is not specifically limited in this application.

The optical filter 34 is disposed on the filter holder 33 and covers the aperture 332. The optical filter 34 is accommodated in the aperture 332, and corresponds to the image sensor 32. Light from outside is filtered through the optical filter 34 and then received by the image sensor 32, and the image sensor 32 converts the light to perform imaging. Specifically, the optical filter 34 is disposed on a top surface (not marked in the figure) of the support part 333 in the aperture 332. For example, the optical filter 34 may be fixed to the top surface of the support part 333 by adhesive bonding. For example, the compact camera module 30 may include a third adhesive bonding layer 70, and the third adhesive bonding layer 70 bonds the optical filter 34 and the filter holder 33 together. The optical filter 34 includes but is not limited to an infrared cut-off filter or a full-transmission spectral filter.

It should be noted that that the optical filter 34 covers the aperture 332 means that the optical filter 34 covers a narrowest section of the aperture 332, and light from outside can enter the filter holder 33 only through the optical filter 34. In another embodiment, the optical filter 34 may alternatively be partially accommodated in the aperture 332, or the optical filter 34 covers the opening of the aperture 332.

The lens holder 35 is disposed on a top side of the filter holder 33. Specifically, the lens holder 35 is fixed to the top surface 331 of the filter holder 33. The lens holder 35 is fixed to an edge area of the top surface 331. For example, the lens holder 35 and the filter holder 33 may be fixed to each other by adhesive bonding. For example, the compact camera module 30 may include a fourth adhesive bonding layer 80, and the fourth adhesive bonding layer 80 bonds the lens holder 35 and the filter holder 33 together. Clearly, in another embodiment, the lens holder 35 and the filter holder 33 may be fixed to each other by welding. For example, the compact camera module 30 may include a solder layer, and the solder layer fixedly connects the lens holder 35 to the filter holder 33.

The lens holder 35 includes a top surface 351 that faces away from the filter holder 33 and a bottom surface 352 that is opposite to the top surface 351. The lens holder 35 includes a mounting groove 353, and an opening of the mounting groove 353 is in a middle area of the top surface 351. The mounting groove 353 extends from the top surface 351 of the lens holder 35 to the bottom surface 352, and goes through the bottom surface 352 of the lens holder 35. In other words, the mounting groove 353 goes through the lens holder 35 in a height direction of the lens holder 35. Specifically, the mounting groove 353 squarely faces the aperture 332. To be specific, the mounting groove 353 squarely faces the image sensor 32. Light outside the compact camera module 30 may enter the filter holder 33 through the mounting groove 353 and the aperture 332, and is received by the image sensor 32.

The lens 36 is disposed on an inside of the lens holder 35. Specifically, the lens 36 is disposed in the mounting groove 353 of the lens holder 35. For example, the lens 36 and the lens holder 35 may be fixed to each other by adhesive bonding. For example, the compact camera module 30 may include a fifth adhesive bonding layer 90, and the fifth adhesive bonding layer 90 bonds the lens 36 and the lens holder 35 together.

The lens 36 is configured to gather light from outside the compact camera module 30. That is, the lens 36 can gather light from outside and project the light from outside into the image sensor 32 through the optical filter 34, to form a corresponding image on the image sensor 32. The lens 36 may include a lens cone and a lens set fixed inside the lens cone. For example, there may be a plurality of lenses in the lens set, for example, five lenses, six lenses, seven lenses, or eight lenses.

The lens holder 35 is a motor. For example, the motor may be an autofocus motor, and the auto-focus motor can drive the lens set to move in a direction parallel to an optical axis of the lens 36. Alternatively, the motor may be an optical image stabilization motor, and the optical image stabilization motor can drive the lens set to move on a plane perpendicular to the optical axis of the lens 36, or drive the lens set to flip to be tilted relative to the optical axis of the lens 36. Alternatively, the motor may be an autofocus and optical image stabilization motor. For example, the motor may be a voice coil motor (voice coil motor, VCM), may be a shape memory alloy-based motor, or the like. A specific function and type of the motor are not strictly limited in this application. In some other embodiments, the lens holder 35 may alternatively be a mount structure. In this case, the compact camera module 30 is a fixed-focus module.

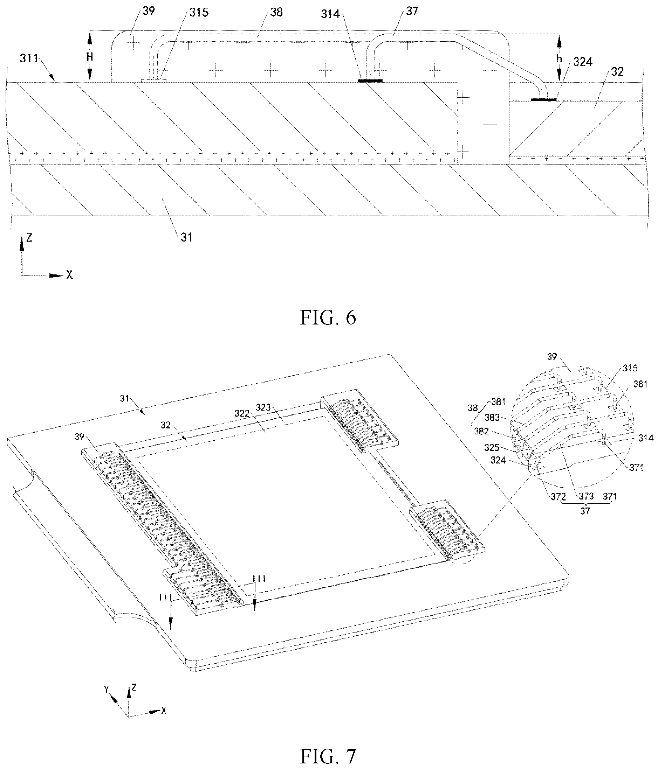

Refer to FIG. 5 and FIG. 6. FIG. 5 is a schematic diagram of a partially assembled structure of the circuit board 31 and the image sensor 32 in the compact camera module 30 shown in FIG. 3. FIG. 6 is a schematic cross-section diagram of the structure shown in FIG. 5 that is cut in a direction II-II.

First gold fingers 314 and second gold fingers 315 that are spaced from each other are disposed on the top surface 311 of the circuit board 31. Specifically, the first gold fingers 314 and the second gold fingers 315 are electrically connected to the circuit board 31, and are both exposed relative to the image sensor 32. The second gold fingers 315 are on a side on which the first gold fingers 314 face away from the image sensor 32. In other words, the second gold fingers 315 and the image sensor 32 are on two sides of the first gold fingers 314.

It should be understood that the first gold fingers 314 and the second gold fingers 315 are not limited to be on the top surface 311 that protrudes from the circuit board 31 as shown in FIG. 6, and may alternatively be embedded in the circuit board 31 and aligned with the top surface 311 of the circuit board 31, or embedded in the circuit board 31 and depressed relative to the top surface 311 of the circuit board 31, that is, embedded in the circuit board 31 and located between the top surface 311 and the bottom surface 311 of the circuit board 311. This is not specifically limited in this application.

In this embodiment, there are a plurality of first gold fingers 314 and a plurality of second gold fingers 315, and the plurality of first gold fingers 314 and the plurality of second gold fingers 315 are all arranged near the opening of the mounting groove 313. Specifically, a part of first gold fingers 314 are arranged in the Y-axis direction and spaced from each other to form a first gold finger set, and a part of first gold fingers 314 are arranged in the Y-axis direction and spaced from each other to form a second gold finger set. The first gold finger set and the second gold finger set are arranged in the X-axis direction and spaced from each other on two opposite sides of the opening of the mounting groove 313.

A part of second gold fingers 315 are arranged in the Y-axis direction and spaced from each other to form a third gold finger set, and a part of second gold fingers 315 are arranged in the Y-axis direction and spaced from each other to form a fourth gold finger set. The third gold finger set and the fourth gold finger are arranged in the X-axis direction and spaced from each other on the two opposite sides of the opening of the mounting groove 313. Specifically, the third gold finger set and the first gold finger set are on a same side of the opening of the mounting groove 313, and are on a side on which the first gold finger set faces away from the opening of the mounting groove 313. To be specific, the third gold finger set and the opening of the mounting groove 313 are on two opposite sides of the first gold fingers 314. The fourth gold finger set and the second gold finger set are on a same side of the opening of the mounting groove 313, and are on a side on which the second gold finger set faces away from the opening of the mounting groove 313. To be specific, the fourth gold finger set and the opening of the mounting groove 313 are on two opposite sides of the second gold finger set.

The image sensor 32 includes a top surface 321 facing a same direction as the top surface 311 of the circuit board 31. The top surface 321 of the image sensor 32 includes a photosensitive area 322 and a non-photosensitive area 323 surrounding the photosensitive area 322. Specifically, the photosensitive area 322 is in a middle area of the top surface 321 of the image sensor 32, and is used to receive light filtered through the optical filter 34. The non-photosensitive area 323 is in an edge area of the top surface 321 of the image sensor 32, and is used for implementing an electrical connection between the image sensor 32 and the circuit board 31.

First pads 324 and second pads 325 that are spaced from each other are disposed on the top surface 321 of the image sensor 32. Specifically, the first pads 324 and the second pads 325 are electrically connected to the image sensor 32, and are both disposed in the non-photosensitive area 323 of the top surface 321. There are a plurality of first pads 324 and a plurality of second pads 325. A part of the first pads 324 and a part of the second pads 325 are in alternately arranged in the Y-axis direction to form a first pad set, and a part of the first pads 324 and a part of the second pads 325 are in alternately arranged in the Y-axis direction to form a second pad set. The first pad set and the second pad set are spaced from each other and arranged in the X-axis direction in the non-photosensitive area 323 of the top surface 321.

It should be understood that the first pads 324 and the second pads 325 are not limited to be on the top surface 321 that protrudes from the image sensor 32 as shown in FIG. 6, and may alternatively be embedded in the image sensor 32 and aligned with the top surface 321 of the image sensor 32, or embedded in the image sensor 32 and depressed relative to the top surface 321 of the image sensor 32, that is, embedded in the image sensor 32 and located between the top surface 321 and the bottom surface (not marked in the figure) of the image sensor 32. This is not specifically limited in this application.

In addition, a quantity of the first pads 324 matches a quantity of the first gold fingers 314, and a quantity of the second pads 325 matches a quantity of the second gold fingers 315. In this embodiment, the quantity of the first pads 324 is equal to the quantity of the first gold fingers 314, and the quantity of the second pads 325 is equal to the quantity of the second gold fingers 315. In some other embodiments, a quantity of the first pads 324 may be greater than or less than a quantity of the first gold fingers 314, and/or a quantity of the second pads 325 may be greater than or less than a quantity of the second gold fingers 315.

The compact camera module 30 further includes first wires 37 and second wires 38. The first wires 37 connect the circuit board 31 and the image sensor 32, and the second wires 38 connect the circuit board 31 and the image sensor 32 and are spaced from the first wires 31. For example, the first wires 37 and the second wires 38 may be made of gold, copper, aluminum, or another material. The image sensor 32 is connected to the substrate 31a of the circuit board 31 through the first wires 37 and the second wires 38, to be electrically connected to the circuit board 31. Both the first wires 37 and the second wires 38 may be formed by a wire bonding (wire bonding, WB) process, and the wire bonding process may also be referred to as a pressure welding process, a bonding process, or a fine wire welding process.

In this embodiment, there are a plurality of first wires 37 and a plurality of second wires 38. A quantity of the first wires 37 is equal to the quantity of the first pads 324 and the quantity of the first gold fingers 314. Each of the first wires 37 connects one of the first gold fingers 314 and one of the first pads 324. Specifically, each of the first wires 37 includes a first end 371, a second end 372, and a connection part 373. The connection part 373 connects the first end 371 and the second end 372. The first end 371 of each first wire 37 is fixedly connected to one of the first gold fingers 314, and the second end 372 is fixedly connected to one of the second pads 325. Lengths of the first wires 37 range from 200 µm to 1,000 µm, and heights (that is, dimensions in the Z-axis direction) of the first wires 37 range from 80 µm to 120 µm.

It should be noted that that the lengths of the first wires 37 range from 200 µm to 1,000 µm means that a length of each first wire 37 may not only be any value between 200 µm and 1,000 µm, but may alternatively be the endpoint value 200 µm or 1,000 µm. Similarly, that the heights of the first wires 37 range from 80 µm to 120 µm means that a height of each first wire 37 may not only be any value between 80 µm and 120 µm, but may alternatively be the endpoint value 80 µm or 120 µm.

A quantity of the second wires 38 is equal to the quantity of the second pads 325 and the quantity of the second gold fingers 315. Each of the second wires 38 connects one of the second gold fingers 315 and one of the second pads 325, and is spaced from an adjacent first wire 37. Specifically, the plurality of second wires 38 and the plurality of first wires 37 are in alternately arranged in a direction parallel to the top surface 311 of the circuit board 31. In the Y-axis direction, the plurality of second wires 38 and the plurality of first wires 37 are in alternately arranged. In this case, a distance w between each second wire 38 and each adjacent first wire 37 is greater than or equal to 40 µm, to avoid a short circuit due to contact between the second wires 38 and the first wires 37.

It should be noted that that the plurality of first wires 37 and the plurality of second wires 38 are in alternately arranged means that the plurality of first wires 37 and the plurality of second wires 37 are not arranged simply one classification after another, but there are one or more second wires 38 between two first wires 37, or there are one or more first wires 37 between two second wires 38.

Specifically, each of the second wires 38 includes a first end 381, a second end 382, and a connection part 383. The connection part 383 connects the first end 381 and the second end 382. The first end 381 of each of the second wires 38 is fixedly connected to one of the second gold fingers 315, and the second end 382 is fixedly connected to one of the second pads 325. Lengths of the second wires 38 are greater than the lengths of the first wires 37, and the lengths of the second wires 38 range from 600 µm to 1,400 µm. Heights of the second wires 38 are equal to the heights of the first wires 37. In some other embodiments, the heights of the second wires 38 may alternatively be different from the heights of the first wires 37. To be specific, the heights of the second wires 38 may be less than the heights of the first wires 37, or the heights of the second wires 38 may be greater than the heights of the first wires 37.

It should be noted that that the lengths of the second wires 38 range from 600 µm to 1,400 µm means that the lengths of the second wires 38 may not only be any value between 600 µm and 1,400 µm, but may alternatively be the endpoint value 600 µm or 1,400 µm.

In addition, the compact camera module 30 further includes insulation adhesive parts 39, and the insulation adhesive parts 39 are in contact with the top surface 311 of the circuit board 31. There are two insulation adhesive parts 39, and the two insulation adhesive parts 39 are arranged in the X-axis direction and spaced from each other on two opposite sides of the image sensor 32. For example, the insulation adhesive parts 39 may be formed after being cured in a manner of natural curing, ultraviolet curing, thermal curing or the like following a dispensing process. Specifically, the insulation adhesive parts 39 cover at least a part of each first wire 37 and a part of each second wire 38. In this embodiment, the insulation adhesive parts 39 cover at least a part of each first wire 37 and a part of each second wire 38 that are close to the circuit board 31. The insulation adhesive parts 39 cover the first end 371 of each first wire 37 and a part, of the connection part 373, that is close to the first end 371, to assist in fixing the first wires 37, improve loop stability of the first wires 37, and prevent the first wires 37 from generating wire sway due to a touch of a person during assembly (for example, an operation, inspection, or reworking procedure) of the compact camera module 30, or generating wire sway because of deformation due to overstress from an external pressure during use, coming in contact with the second wires 38, and generating a short circuit.

In addition, a maximum distance H between the insulation adhesive parts 39 and the top surface 311 of the circuit board 31 is greater than a maximum distance h between the first wires 37 and the top surface 311 of the circuit board 31. In other words, the insulation adhesive parts 39 cover highest positions of the first wires 37, so that the first wires 37 can be effectively prevented from sagging, and the loop stability of the first wires 37 is improved. The highest positions of the first wires 37 refer to positions of the first wires 37 that are farthest from the top surface 311 of the circuit board 31.

The insulation adhesive parts 39 cover the first end 381 of each second wire 38 and a part, of the connection part 383, that is close to the first end 381, to assist in fixing the second wires 38, and prevent the second wires 38 from generating a wire sway due to a touch of a person during assembly of the compact camera module 30 or overstress during use, coming in contact with the first wires 37, and generating a short circuit, thereby reducing a fault feedback ratio (fault feedback ratio, FFR) of the compact camera module 30. It can be understood that, because the heights of the second wires 38 are the same as the heights of the first wires 37, the insulation adhesive parts 39 also cover highest positions of the second wires 38, to prevent the second wires 38 from generating sag due to a touch of a person during assembly of the compact camera module 30 or overstress during use, coming in contact with the first gold fingers 314, and generating a short circuit.

It should be noted that, in some other embodiments, the insulation adhesive parts 39 may not cover the highest positions of the first wires 37 and/or the second wires 38. When the second wires 38 sags, the second wires 38 do not come in contact with the first gold fingers 314 because of separation of the insulation adhesive part 39, and a short circuit does not occur. In this case, because the insulation adhesive parts 39 do not cover the highest points of the first wires 37 and/or the second wires 38, an internal height of the filter holder 33 fixed above the circuit board 31 is reduced, thereby helping reduce the height of the compact camera module 30, and achieving a compact design of the compact camera module 30.

The insulation adhesive parts 39 are in contact with a lateral surface of the image sensor 32, and cover the first gold fingers 314 and the second gold fingers 315, to improve connection stability of the insulation adhesive parts 39 and the circuit board 31, thereby improving an effect of fixing the first wires 37 and the second wires 38 to the insulation adhesive parts 39. It should be understood that, in a dispensing process, a fluid adhesive flows within a specific area. Therefore, the insulation adhesive parts 39 cover a part of an area near the first gold fingers 314 and the second gold fingers 315. As shown in FIG. 6, the insulation adhesive parts 39 further cover a part of an area of the top surface 311 of the circuit board 31, to improve connection stability of the insulation adhesive parts 39 and the circuit board 31. In addition, a part of the insulation adhesive parts 39 is in the mounting groove 313, and connects a side surface of the image sensor 32 and the groove side wall of the mounting groove 313, to further improve connection stability of the insulation adhesive parts 39 and the circuit board 31. It can be understood that a size of coverage of the insulation adhesive parts 39 over the top surface 311 of the circuit board 31 may be controlled by selection of adhesive viscosity, control of a dispensing path, using a curing parameter, or another process.

It should be noted that, in some other embodiments, a third gold finger may be further disposed on the top surface 311 of the circuit board 31, a third pad may be further disposed on the top surface 321 of the image sensor 32, and the compact camera module 30 may further include a third wire. The third wire connects the third gold finger and the third pad, and the insulation adhesive parts 39 may cover a part or all of the third wire. This is not specifically limited in this application.

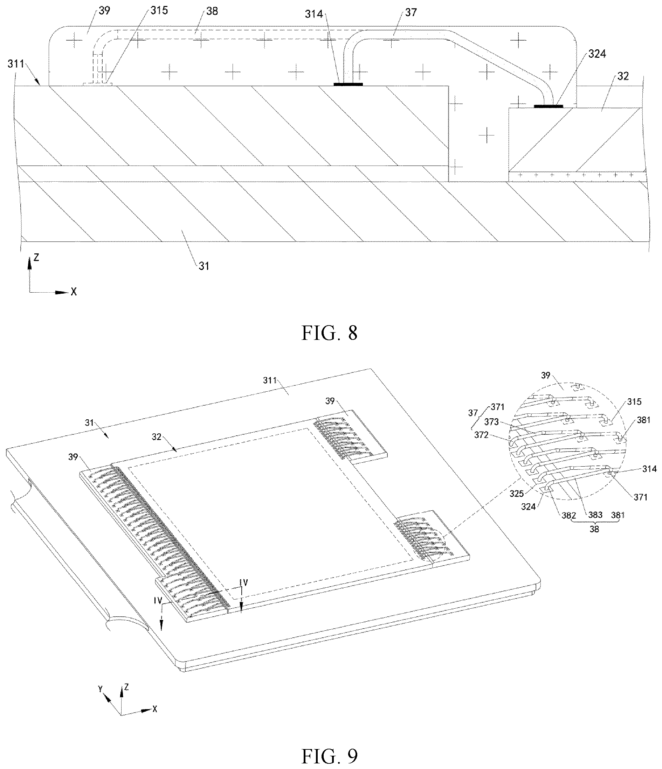

Refer to FIG. 7 and FIG. 8. FIG. 7 is a schematic diagram of a partially assembled structure of the circuit board 31 and the image sensor 32 in a compact camera module of a second electronic device according to an embodiment of this application. FIG. 8 is a schematic cross-section diagram of the structure shown in FIG. 7 that is cut in a direction III-III.

A difference between the electronic device shown in this embodiment and the electronic device shown in the foregoing embodiment lies in that the insulation adhesive parts 39 further contact the top surface 321 of the image sensor 32, and cover a part of each first wire 37 and a part of each second wire 38 that are close to the image sensor 32. Specifically, the insulation adhesive parts 38 fully cover the first wires 37 and the second wires 38. The insulation adhesive parts 39 cover the first end 371, the connection part 373, and the second end 372 of each first wire 37, and the first end 381, the connection part 383, and the second part 382 of each second wire 38, to fix the first wires 37 and the second wires 38 and prevent the first and second wires from generating wire sway, coming in contact with each other, and generating a short circuit.

In this case, the insulation adhesive parts 39 further cover the first pads 324 and the second pads 325, to improve connection stability of the insulation adhesive parts 39 and the image sensor 32 and improve an effect of fixing the first wires 37 and the second wires 38 to the insulation adhesive parts 39. It should be understood that, in a dispensing process, a fluid adhesive flows within a specific area. Therefore, the insulation adhesive parts 39 further cover a part of an area near the first pads 324 and the second pads 325. As shown in FIG. 8, the insulation adhesive parts 39 further cover a part of an area of the top surface 321 of the image sensor 32, to improve connection stability of the insulation adhesive parts 39 and the image sensor 32. In this case, the insulation adhesive parts 39 cover a part of the non-photosensitive area 323 of the image sensor 32. To be specific, the insulation adhesive parts 39 are outside the photosensitive area 322 of the image sensor 32, that is, the insulation adhesive parts 39 do not cover the photosensitive area 322 of the image sensor 32, to prevent the insulation adhesive parts 39 from affecting the photosensitive area 322 on receiving light for imaging.

In the electronic device 100 shown in this embodiment, a simple dispensing and curing device may be used, and the insulation adhesive parts 39 may be formed after a dispensing and curing process to protect the first wires 37 and the second wires 38, without a need to use a high-precision plastic packaging mold for plastic packaging of the first wires 37 and the second wires 38. This avoids a microcrack or even damage due to excessive stress on the image sensor 32 if the image sensor 32 is squeezed by the plastic packaging mold, and helps reduce production costs of the compact camera module 30 and improve a yield rate.

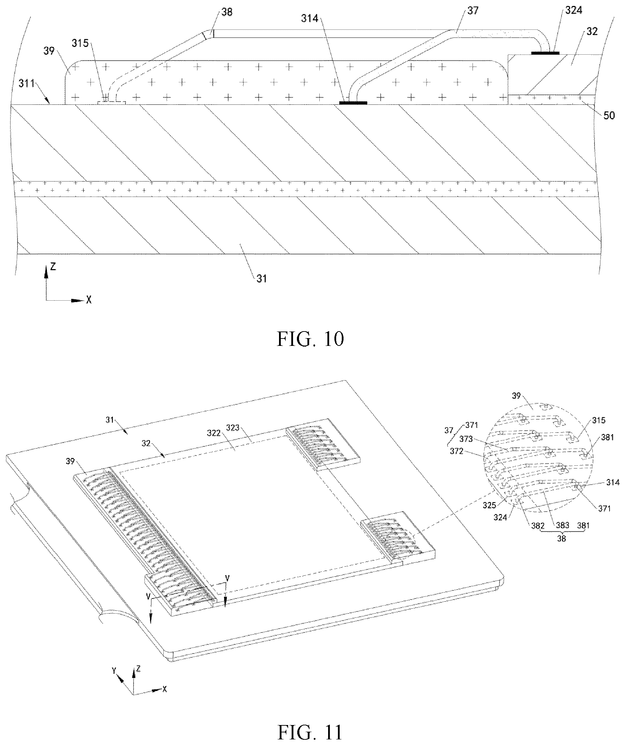

Refer to FIG. 9 and FIG. 10. FIG. 9 is a schematic diagram of a partially assembled structure of the circuit board 31 and the image sensor 32 in a compact camera module of a third electronic device according to an embodiment of this application. FIG. 10 is a schematic cross-section diagram of the structure shown in FIG. 9 that is cut in a direction IV-IV.

A difference between the electronic device shown in this embodiment and the electronic device shown in the first embodiment described above lies in that the image sensor 32 is disposed on the top surface 311 of the circuit board 31. Specifically, the image sensor 32 is disposed in a middle area of the top surface 311 of the circuit board 31. For example, the image sensor 32 may be disposed on the top surface of the circuit board 31 by adhesive bonding. For example, the compact camera module 30 may include a first adhesive bonding layer 50, and the first adhesive bonding layer 50 bonds the image sensor 32 and the circuit board 31 together.

In this embodiment, the insulation adhesive parts 39 cover a part of each first wire 37 and a part of each second wire 38. Specifically, the insulation adhesive parts 39 cover the first end 371 of each first wire 37 and a part, of the connection part 373, that is close to the first end 371. A height H of each insulation adhesive part 39 in a positive direction of the Z-axis is less than a height h of each first wire 37 in a positive direction of the Z-axis. In other words, the insulation adhesive parts 39 do not cover the highest points of the first wires 37.

The insulation adhesive parts 39 cover the first end 381 of each second wire 38 and a part, of the connection part 373, that is close to the first end 371. The insulation adhesive parts 39 do not cover the highest points of the second wires 38. When the second wires 38 sags, the second wires 38 do not come in contact with the first gold fingers 314 because of separation of the insulation adhesive part 39, and a short circuit does not occur.

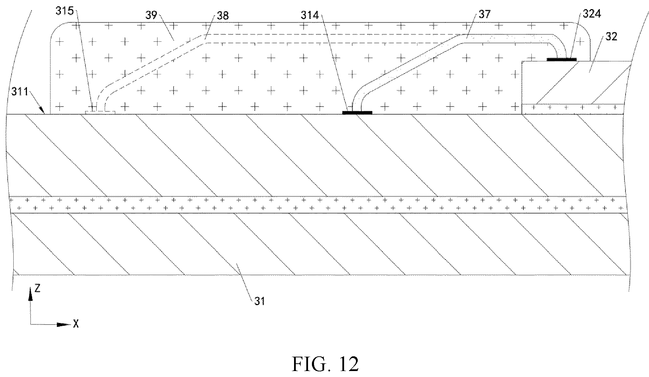

Refer to FIG. 11 and FIG. 12. FIG. 11 is a schematic diagram of a partially assembled structure of the circuit board 31 and the image sensor 32 in a compact camera module of a fourth electronic device according to an embodiment of this application. FIG. 12 is a schematic cross-section diagram of the structure shown in FIG. 11 that is cut in a direction V-V

A difference between the electronic device shown in this embodiment and the electronic device shown in the third embodiment described above lies in that the insulation adhesive parts 39 cover the first wires 37 and the second wires 38. Specifically, the insulation adhesive parts 39 cover the first end 371, the connection part 373, and the second end 372 of each first wire 37, and the first end 381, the connection part 373, and the second part of each second wire 38. To be specific, the insulation adhesive parts 39 fully cover the first wires 37 and the second wires 38, to fix the first wires 37 and the second wires 38, and avoid a short circuit when the wires come in contact with each other because of wire sway.

In addition, the insulation adhesive parts 39 further cover the first pads 324 and the second pads 325, to improve connection stability of the insulation adhesive parts 39 and the image sensor 32 and improve an effect of fixing the first wires 37 and the second wires 38 to the insulation adhesive parts 39. It should be understood that, in a dispensing process, a fluid adhesive flows within a specific area. Therefore, the insulation adhesive parts 39 further cover a part of an area near the first pads 324 and the second pads 325. As shown in FIG. 12, the insulation adhesive parts 39 further cover a part of an area of the top surface 321 of the image sensor 32, to improve connection stability of the insulation adhesive parts 39 and the image sensor 32. In this case, the insulation adhesive parts 39 cover a part of the non-photosensitive area of the image sensor 32. To be specific, the insulation adhesive parts 39 do not cover the photosensitive area of the image sensor 32, to prevent the insulation adhesive parts 39 from affecting the photosensitive area on receiving light for imaging.

The foregoing descriptions are merely some embodiments and implementations of this application. The embodiments of this application and the features in the embodiments may be combined with each other when there is no conflict. Therefore, the protection scope of this application shall be subject to the protection scope of the claims.

## Claims

1. A compact camera module (30), comprising an image sensor (32), a circuit board (31), first wires (37), second wires (38), and an insulation adhesive part (39), wherein the image sensor (32) is disposed on the circuit board (31), the first wires (37) connect the circuit board (31) to the image sensor (32), the second wires (38) connect the circuit board (31) to the image sensor (32) and are spaced from the first wires (37), lengths of the second wires (38) are greater than lengths of the first wires (37), and the insulation adhesive part (39) covers at least a part of each first wire (37) and a part of each second wire (38) that are close to the circuit board (31),
**characterized in that** the insulation adhesive part (39) is in contact with a top surface (311) of the circuit board (31).

2. The compact camera module (30) according to claim 1, wherein there are a plurality of first wires (37) and a plurality of second wires (38), and the plurality of first wires (37) and the plurality of second wires (38) are in alternately arranged in a direction parallel to the top surface (311) of the circuit board (31).

3. The compact camera module (30) according to claim 1 or 2, wherein the insulation adhesive part (39) is further in contact with a top surface (321) of the image sensor (32) and covers a part of each first wire (37) and a part of each second wire (38) that are close to the image sensor (32).

4. The compact camera module (30) according to claim 3, wherein the top surface (321) of the image sensor (32) comprises a photosensitive area (322), and the insulation adhesive part (39) is outside the photosensitive area (322).

5. The compact camera module (30) according to claim 1, wherein the insulation adhesive part (39) covers highest positions of the first wires (37) and the second wires (38).

6. The compact camera module (30) according to claim 1, wherein the insulation adhesive part (39) fully covers the first wires (37) and the second wires (38).

7. The compact camera module (30) according to claim 1, wherein the image sensor (32) is disposed on the top surface (311) of the circuit board (31), or the circuit board (31) is provided with a mounting groove (313), an opening of the mounting groove (313) is on the top surface (311) of the circuit board (31), the image sensor (32) is disposed on the mounting groove (313), and the insulation adhesive part (39) is further in contact with a lateral surface of the image sensor (32).

8. The compact camera module (30) according to claim 1, wherein first pads (324) and second pads (325) that are spaced from each other are disposed on a top surface (321) of the image sensor (32), first gold fingers (314) and second gold fingers (315) that are spaced from each other are disposed on the top surface (311) of the circuit board (31), the first gold fingers (314) and the second gold fingers (315) are exposed relative to the image sensor (32), the second gold fingers (315) are on a side on which the first gold fingers (314) face away from the image sensor (32), so that, the second gold fingers 315 and the image sensor 32 are on two sides of the first gold fingers (314), the first wires (37) connect the first gold fingers (314) to the first pads (324), the second wires (38) connect the second gold fingers (315) to the second pads (325), and the insulation adhesive part (39) covers the first gold fingers (314) and the second gold fingers (315).

9. The compact camera module (30) according to claim 1, wherein the lengths of the first wires (37) range from 200 µm to 1,000 µm, and the lengths of the second wires (38) range from 600 µm to 1,400 µm.

10. The compact camera module (30) according to claim 1, wherein a distance between each first wire (37) and each second wire (38) is greater than or equal to 40 µm.

11. The compact camera module (30) according to claim 1, wherein the compact camera module (30) further comprises a filter holder (33), an optical filter (34), a lens holder (35), and a lens (36), the filter holder (33) is disposed on a top side of the circuit board (31), the filter holder (33) has an aperture (332) corresponding to the image sensor (32), the optical filter (34) is disposed on the filter holder (33) and covers the aperture (332), the lens holder (35) is disposed on a top side of the filter holder (33), and the lens (36) is disposed on an inside of the lens holder (35).

12. An electronic device (100), comprising a housing (10) and the compact camera module (30) according to any one of claims 1 to 11, wherein the compact camera module (30) is disposed inside the housing (10).

## Patentansprüche

1. Kompaktkameramodul (30), umfassend einen Bildsensor (32), eine Leiterplatte (31), erste Drähte (37), zweite Drähte (38) und einen Isolierklebstoffteil (39), wobei der Bildsensor (32) auf der Leiterplatte (31) angeordnet ist, die ersten Drähte (37) die Leiterplatte (31) mit dem Bildsensor (32) verbinden, die zweiten Drähte (38) die Leiterplatte (31) mit dem Bildsensor (32) verbinden und von den ersten Drähten (37) beabstandet sind, Längen der zweiten Drähte (38) größer als Längen der ersten Drähte (37) sind und der Isolierklebstoffteil (39) zumindest einen Teil jedes ersten Drahts (37) und einen Teil jedes zweiten Drahts (38) bedeckt, die sich nahe der Leiterplatte (31) befinden,
**dadurch gekennzeichnet, dass** der Isolierklebstoffteil (39) in Kontakt mit einer oberen Fläche (311) der Leiterplatte (31) steht.

2. Kompaktkameramodul (30) nach Anspruch 1, wobei eine Mehrzahl von ersten Drähten (37) und eine Mehrzahl von zweiten Drähten (38) vorhanden ist und die Mehrzahl von ersten Drähten (37) und die Mehrzahl von zweiten Drähten (38) in einer Richtung parallel zu der oberen Fläche (311) der Leiterplatte (31) abwechselnd angeordnet sind.

3. Kompaktkameramodul (30) nach Anspruch 1 oder 2, wobei der Isolierklebstoffteil (39) ferner in Kontakt mit einer oberen Fläche (321) des Bildsensors (32) steht und einen Teil jedes ersten Drahts (37) und einen Teil jedes zweiten Drahts (38) bedeckt, die sich nahe des Bildsensors (32) befinden.

4. Kompaktkameramodul (30) nach Anspruch 3, wobei die obere Fläche (321) des Bildsensors (32) einen lichtempfindlichen Bereich (322) umfasst und der Isolierklebstoffteil (39) außerhalb des lichtempfindlichen Bereichs (322) liegt.

5. Kompaktkameramodul (30) nach Anspruch 1, wobei der Isolierklebstoffteil (39) die höchsten Positionen der ersten Drähte (37) und der zweiten Drähte (38) bedeckt.

6. Kompaktkameramodul (30) nach Anspruch 1, wobei der Isolierklebstoffteil (39) die ersten Drähte (37) und die zweiten Drähte (38) vollständig bedeckt.

7. Kompaktkameramodul (30) nach Anspruch 1, wobei der Bildsensor (32) auf der oberen Fläche (311) der Leiterplatte (31) angeordnet ist oder die Leiterplatte (31) mit einer Montagenut (313) versehen ist, wobei eine Öffnung der Montagenut (313) auf der oberen Fläche (311) der Leiterplatte (31) liegt, der Bildsensor (32) auf der Montagenut (313) angeordnet ist und der Isolierklebstoffteil (39) ferner in Kontakt mit einer lateralen Fläche des Bildsensors (32) steht.

8. Kompaktkameramodul (30) nach Anspruch 1, wobei erste Kontaktflächen (324) und zweite Kontaktflächen (325), die voneinander beabstandet sind, auf einer oberen Fläche (321) des Bildsensors (32) angeordnet sind, wobei erste Goldfinger (314) und zweite Goldfinger (315), die voneinander beabstandet sind, auf der oberen Fläche (311) der Leiterplatte (31) angeordnet sind, wobei die ersten Goldfinger (314) und die zweiten Goldfinger (315) relativ zu dem Bildsensor (32) freiliegen, wobei sich die zweiten Goldfinger (315) auf einer Seite befinden, auf der die ersten Goldfinger (314) von dem Bildsensor (32) weg zeigen, so dass sich die zweiten Goldfinger 315 und der Bildsensor 32 auf zwei Seiten der ersten Goldfinger (314) befinden, wobei die ersten Drähte (37) die ersten Goldfinger (314) mit den ersten Kontaktflächen (324) verbinden, die zweiten Drähte (38) die zweiten Goldfinger (315) mit den zweiten Kontaktflächen (325) verbinden und der Isolierklebstoffteil (39) die ersten Goldfinger (314) und die zweiten Goldfinger (315) bedeckt.

9. Kompaktkameramodul (30) nach Anspruch 1, wobei die Längen der ersten Drähte (37) im Bereich von 200 µm bis 1.000 µm liegen und die Längen der zweiten Drähte (38) im Bereich von 600 µm bis 1.400 µm liegen.

10. Kompaktkameramodul (30) nach Anspruch 1, wobei ein Abstand zwischen jedem ersten Draht (37) und jedem zweiten Draht (38) größer als oder gleich 40 µm ist.

11. Kompaktkameramodul (30) nach Anspruch 1, wobei das Kompaktkameramodul (30) ferner einen Filterhalter (33), ein optisches Filter (34), einen Linsenhalter (35) und eine Linse (36) umfasst, wobei der Filterhalter (33) auf einer oberen Seite der Leiterplatte (31) angeordnet ist, der Filterhalter (33) einen Durchgang (332) aufweist, der dem Bildsensor (32) entspricht, das optische Filter (34) auf dem Filterhalter (33) angeordnet ist und den Durchgang (332) bedeckt, der Linsenhalter (35) auf einer oberen Seite des Filterhalters (33) angeordnet ist und die Linse (36) auf einer Innenseite des Linsenhalters (35) angeordnet ist.

12. Elektronisches Gerät (100), umfassend ein Gehäuse (10) und das Kompaktkameramodul (30) nach einem der Ansprüche 1 bis 11, wobei das Kompaktkameramodul (30) in dem Gehäuse (10) angeordnet ist.

## Revendications

1. Module de caméra compact (30), comprenant un capteur d'image (32), une carte de circuit (31), des premiers fils (37), des seconds fils (38), et une partie adhésive d'isolation (39), le capteur d'image (32) étant disposé sur la carte de circuit (31), les premiers fils (37) connectant la carte de circuit (31) au capteur d'image (32), les seconds fils (38) connectant la carte de circuit (31) au capteur d'image (32) et étant espacés des premiers fils (37), les longueurs des seconds fils (38) étant supérieures aux longueurs des premiers fils (37), et la partie adhésive d'isolation (39) couvrant au moins une partie de chaque premier fil (37) et une partie de chaque second fil (38) qui sont proches de la carte de circuit (31),
**caractérisé en ce que** la partie adhésive d'isolation (39) est en contact avec une surface supérieure (311) de la carte de circuit (31).

2. Module de caméra compact (30) selon la revendication 1, une pluralité de premiers fils (37) et une pluralité de seconds fils (38) existant, et la pluralité de premiers fils (37) et la pluralité de seconds fils (38) étant agencées en alternance dans une direction parallèle à la surface supérieure (311) de la carte de circuit (31).

3. Module de caméra compact (30) selon la revendication 1 ou 2, la partie adhésive d'isolation (39) étant en outre en contact avec une surface supérieure (321) du capteur d'image (32) et couvrant une partie de chaque premier fil (37) et une partie de chaque second fil (38) qui sont proches du capteur d'image (32).

4. Module de caméra compact (30) selon la revendication 3, la surface supérieure (321) du capteur d'image (32) comprenant une zone photosensible (322), et la partie adhésive d'isolation (39) étant en dehors de la zone photosensible (322).

5. Module de caméra compact (30) selon la revendication 1, la partie adhésive d'isolation (39) couvrant les positions les plus élevées des premiers fils (37) et des seconds fils (38).

6. Module de caméra compact (30) selon la revendication 1, la partie adhésive d'isolation (39) couvrant complètement les premiers fils (37) et les seconds fils (38).

7. Module de caméra compact (30) selon la revendication 1, le capteur d'image (32) étant disposé sur la surface supérieure (311) de la carte de circuit (31), ou la carte de circuit (31) étant pourvue d'une rainure de montage (313), une ouverture de la rainure de montage (313) étant sur la surface supérieure (311) de la carte de circuit (31), le capteur d'image (32) étant disposé sur la rainure de montage (313), et la partie adhésive d'isolation (39) étant en outre en contact avec une surface latérale du capteur d'image (32).

8. Module de caméra compact (30) selon la revendication 1, des premières plages (324) et des secondes plages (325) espacées les unes des autres étant disposées sur une surface supérieure (321) du capteur d'image (32), des premiers doigts dorés (314) et des seconds doigts dorés (315) espacés les uns des autres étant disposés sur la surface supérieure (311) de la carte de circuit (31), les premiers doigts dorés (314) et les seconds doigts dorés (315) étant exposés par rapport au capteur d'image (32), les seconds doigts dorés (315) étant sur un côté sur lequel les premiers doigts dorés (314) font face dans la direction opposée au capteur d'image (32), de sorte que les seconds doigts dorés 315 et le capteur d'image 32 soient sur deux côtés des premiers doigts dorés (314), les premiers fils (37) connectant les premiers doigts dorés (314) aux premières plages (324), les seconds fils (38) connectant les seconds doigts dorés (315) aux secondes plages (325), et la partie adhésive d'isolation (39) couvrant les premiers doigts dorés (314) et les seconds doigts dorés (315).

9. Module de caméra compact (30) selon la revendication 1, les longueurs des premiers fils (37) s'étendant de 200 µm à 1000 µm, et les longueurs des seconds fils (38) s'étendant de 600 µm à 1400 µm.

10. Module de caméra compact (30) selon la revendication 1, une distance entre chaque premier fil (37) et chaque second fil (38) étant supérieure ou égale à 40 µm.

11. Module de caméra compact (30) selon la revendication 1, le module de caméra compact (30) comprenant en outre un support de filtre (33), un filtre optique (34), un support d'objectif (35), et un objectif (36), le support de filtre (33) étant disposé sur un côté supérieur de la carte de circuit (31), le support de filtre (33) ayant une ouverture (332) correspondant au capteur d'image (32), le filtre optique (34) étant disposé sur le support de filtre (33) et couvrant l'ouverture (332), le support d'objectif (35) étant disposé sur un côté supérieur du support de filtre (33), et l'objectif (36) étant disposé à l'intérieur du support d'objectif (35).

12. Dispositif électronique (100), comprenant un boîtier (10) et le module de caméra compact (30) selon l'une quelconque des revendications 1 à 11, le module de caméra compact (30) étant disposé à l'intérieur du boîtier (10).
